# EUROPÄISCHE PATENTSCHRIFT

(11) **EP 1 241 148 B1**
(45) Veröffentlichungstag und Bekanntmachung des Hinweises auf die Patenterteilung: **09.07.2008**
(21) Anmeldenummer: 01890082.9
(22) Anmeldetag: 16.03.2001
(51) Int. Cl.: C04B 37/02, C04B 41/85

(54) **AIuminiumnitridsubstrat sowie Verfahren zur Vorbereitung dieses Substrates auf die Verbindung mit einer Kupferfolie**
Aluminium nitride substrate and method of preparing this substrate for joining with a copper foil
Substrat en nitrure d'aluminium et procédé de preparation de ce substrat à la liaison avec une feuille de cuivre

(43) Veröffentlichungstag der Anmeldung: 18.09.2002
(73) Patentinhaber: ELECTROVAC, FABRIKATION ELEKTROTECHNISCHER SPEZIALARTIKEL GESELLSCHAFT M.B.H., 3400 Klosterneuburg (AT)
(72) Erfinder: Topitsch, Herbert, Dr., 1030 Wien (AT)
(74) Vertreter: Gibler, Ferdinand

(56) Entgegenhaltungen:
- US-A- 4 737 416
- PATENT ABSTRACTS OF JAPAN vol. 1995, no. 02, 31. März 1995 (1995-03-31) & JP 06 321663 A (MITSUBOSHI BELTING LTD.), 22. November 1994 (1994-11-22)

## Beschreibung

Die Erfindung bezieht sich auf ein AlN-Substrat mit wenigstens einer, im wesentlichen aus AlN bestehenden Schicht, die an wenigstens einer Oberflächenseite mit einer Hilfsschicht versehen ist, auf welcher eine Kupferfolie mittels eines Direct-Copper-Bonding- (DCB-)Verfahrens festlegbar ist und auf ein Verfahren zur Vorbereitung eines AlN-Substrates auf die Verbindung mit einer Kupferfolie mittels eines Direct-Copper-Bonding- (DCB-)Verfahrens, bei dem auf zumindest eine Oberflächenseite des AlN-Substrates zur Herstellung einer Hilfsschicht eine Schicht aus Kupfer, Kupferoxid oder anderen kupferhältigen Verbindungen aufgebracht wird und anschließend ein Oxidationsvorgang durchgeführt wird, bei welchem in der Schicht CuAl₂O₄ ausgebildet wird.

In den letzten Jahren entwickelte sich besonders im Bereich der Regelelektronik für Elektroaggregate eine sehr kostengünstige Bauweise von intelligenten Leistungshalbleitersteuerungen mittels Kupfer - Keramik - Sandwich - Substraten. Die aus diesem Material bestehenden hochwertigen Leiterplatten sind unter dem Namen DCB (Direct Copper Bonded) Substrate bekannt geworden und ermöglichen ein wesentlich verbessertes Wärmemanagement bei der Leistungselektronik. Die für diese Anwendungen üblicherweise verwendeten Keramiken bestehen aus Al₂O₃. Al₂O₃ hat eine Wärmeleitfähigkeit von 20 bis 35W/mK. Da in der Leistungselektronik die Tendenz zu immer stärkerer Integration und

Miniaturisierung zu beobachten ist, wird auf immer kleineren Flächen immer mehr Wärme produziert. Deshalb wird heute ein Einsatz von Aluminiumnitrid als Ersatz von Aluminiumoxid angestrebt, da Aluminiumnitrid eine wesentlich bessere Wärmeleitfähigkeit (Wärmeleitfähigkeit bis zu 350W/mK) hat. Weiters ist der Ausdehnungskoeffizient von AlN wesentlich besser an Si angepaßt als Al₂O₃. Der Ausdehnungskoeffizient von AlN liegt bei etwa 5 x10⁻⁶/°C, der von Si bei 4 x10⁻⁶/°C und der von Al₂O₃ bei 8 x10⁻⁶/°C. Auch aus diesem Grund ist der Einsatz von AlN sehr wünschenswert. Die heute verwendeten AlN-Plattengrößen liegen alle im Bereich von 1x1 Zoll oder 2x2 Zoll. Aus wirtschaftlichen Überlegungen wird der Einsatz von größeren Platten angestrebt. Das heutige technisch fertigbare Maximum sind 5x7 Zoll AlN-Platten.

Leider ist der heute in großem Umfang verbreitete DCB-Prozeß für AlN nicht anwendbar, da die AlN-Keramik von der eutektischen Schmelze nicht benetzt wird. Es wurden verschiedene Verfahren vorgeschlagen, mit denen eine Verbindung von Kupferfolien mit einer AlN-Keramik möglich sein sollen. In einigen Verfahren wurden spezielle Stoffe der AlN-Keramik zugegeben, um eine für eine Bondung geeignete Oberfläche zu erhalten. In anderen Verfahren wurde die Oberfläche der AlN-Keramik einer speziellen Behandlung unterzogen, um eine Benetzung durch die eutektische Schmelze Kupferoxid/Kupfer zu ermöglichen.

In DE 9407157 wird beschrieben, daß zur Nitridkeramik außer den an sich bekannten und nötigen Sinterhilfsstoffen noch Legierungshilfsstoffe zugegeben werden sollen, wobei die Summe aller Zuschlagstoffe zwischen 0.1% und 7 Gew.% O liegen soll, um bei der Oxidation der Oberfläche eine möglichst dichte Oxidschicht zu erhalten. Der Nachteil dieser Erfindung liegt darin, daß durch die Vielzahl an Legierungszusätzen die Wärmeleitfähigkeit sehr stark herabgesetzt wird.

In DE 35 34 886 wird ein Verfahren beschrieben, bei dem die Oberfläche einer speziellen Wärmebehandlung unterzogen wurde, um eine bessere Haftung der Metallfolien zu erreichen. Bei diesem Verfahren soll die Oberflächenrauhigkeit auf unter 10µm durch eine Wärmebehandlung abgesenkt werden.

In EP 516 819, US 5 418 002 und WO 92/11113 wird das Oxidieren von AlN in einer wasserdampfhaltigen Atmosphäre beschrieben. Mit diesem Verfahren wird eine Oberfläche erzielt, auf der gut gebondet werden können soll. Dieses Verfahren funktioniert leider nicht bei größeren Platten; es ist für Plattengrößen von 2x2 Zoll beschrieben. Bei dieser Größe der AlN-Platten fallen die unterschiedlichen Ausdehnungskoeffizienten noch nicht sehr dramatisch ins Gewicht. Bei einer angestrebten Größe von 5x7 Zoll ergeben sich alleine durch die unterschiedlichen Ausdehnungen von AlN und Al₂O₃ schon Längenunterschiede, die in den Bereich von einem Millimeter und darüber gehen. Speziell bei der hohen Temperatur von 1250°C, die im Patent angeführt ist, ergibt sich rein rechnerisch über die lange Seite (7 Zoll) ein Ausdehnungsunterschied zwischen Oxid- und Nitridschicht von 3 mm.

In US 5 275 770 und DE 38 44 264 wird die Herstellung eines Verbundkörpers aus AlN und Al₂O₃ beschrieben. Auf diesen Verbundkörpern soll es möglich sein, mit dem DCB-Verfahren Kupfer aufzubonden. In DE 41 04 860 wird die Herstellung einer Oxidschicht unter kontrollierter feuchtigkeitsfreier oxidierender Atmosphäre durchgeführt. Auf dieser Oberfläche wird mit dem DCB-Verfahren Kupfer gebondet.

In weiteren Patenten wird das Aufbringen der Oxidschicht durch Aufspinnen, Flammspritzen, Siebdrucken oder gleichzeitiges Sintern von Al₂O₃ und AlN beschrieben. Bei umfangreichen eigenen Untersuchungen konnten mit diesen Verfahren keine homogenen blasenfreie Kupfer-Keramikverbindungen erhalten werden.

In DE 196 03 822 C2 wird beschrieben, daß eine dünne Schicht aus Kupfer, Kupferoxid oder anderen kupferhältigen Verbindungen auf eine AlN-Keramik aufgebracht wird. Diese Schicht wird in sauerstoffhältiger Atmosphäre bei etwa 1280°C behandelt, wobei an der AlN-Oberfläche eine Hilfsschicht entsteht, die im wesentlichen aus Al₂O₃ besteht und in welcher ein Kupferoxid enthalten ist. Auf diese Hilfsschicht wird mit dem bekannten DCB-Verfahren eine Kupferfolie angebondet.

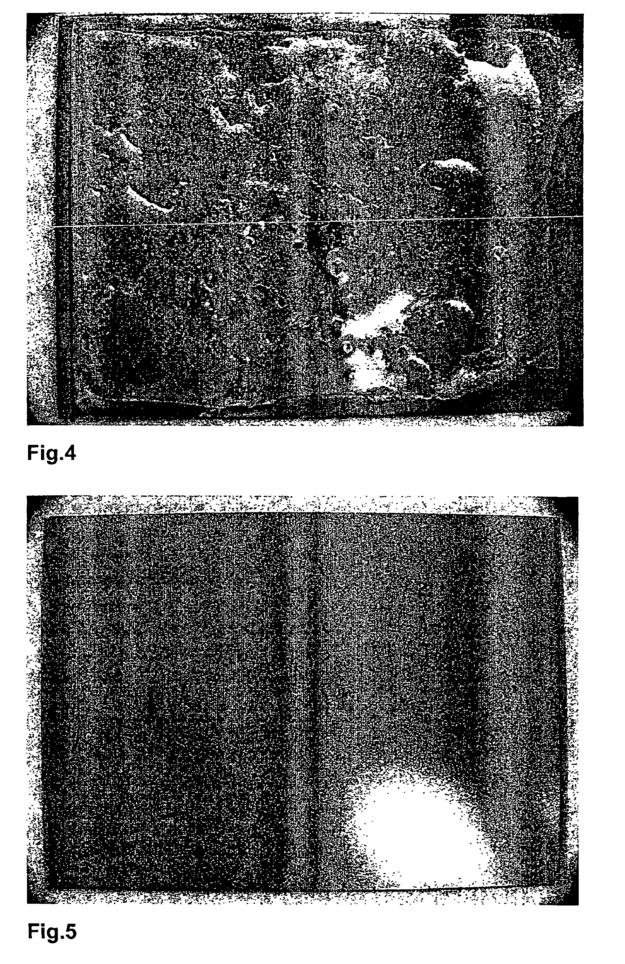

In umfangreichen eigenen Untersuchungen konnten diese Ergebnisse aber nicht wiederholt werden. Insbesondere zeigte sich, daß beim Bonden die aufgelegte Kupferfolie aufschmilzt. Die Analyse der Versuche ergab, daß das beim Oxidationsprozeß gebildete CuO bei den Bondbedingungen zu Cu₂O reduziert wird und gleichzeitig Sauerstoff frei wird. Dieser zusätzliche Sauerstoff verändert die Atmosphäre beim Bonden in der Art, daß zuviel Sauerstoff während des Bondprozesses vorliegt; das führt zu einem Aufschmelzen der aufgelegten Kupferfolie (vgl. Fig.4, welche ein Photo einer derartigen, beim Bondvorgang aufgeschmolzenen Kupferfolie zeigt).

In JP 6321663 wird das Aufbringen von Cu, Cu₂O oder CuO beschrieben. Diese Pulver sind in einem Polymer dispergiert und werden anschließend bei Temperaturen zwischen 700 und 900°C thermisch oxidiert. Auch dieses Verfahren liefert keine reproduzierbaren Ergebnisse, da selbst bei nur geringen Abweichungen unterschiedliche Resultate erhalten werden.

Aufgabe der Erfindung ist es, ein AlN-Substrat der eingangs angeführten Art, also ein mit einer Hilfsschicht versehenes AlN-Substrat anzugeben, auf welcher Hilfsschicht eine Kupferfolie mittels eines Direct-Copper-Bonding- (DCB-)Verfahrens festlegbar ist. Bei diesem AlN-Substrat sollen die vorgenannten Nachteile des bekannten Standes der Technik, nämlich die schlechte Reproduzierbarkeit qualitativ guter Bondprozesse vermieden sein und selbst das Aufbonden von großflächigen Kupferfolien (>4x4 Zoll) auf das AlN-Substrat ohne Fehlstellen möglich sein.

Erfindungsgemäß wird dies dadurch erreicht, daß diese Hilfsschicht zu zumindest 50 Gew.-% aus CuAlO₂ besteht und im Überschuß vorhandenes Cu₂O enthält.

Unterschiedlich zum bisherigen Stand der Technik, gemäß welchem die auf das AlN-Substrat aufgebrachte, mit dem Cu/CuO-Eutektikum benetzbare Schicht vornehmlich Al₂O₃ enthalten hat, enthält die erfindungsgemäße Hilfsschicht vornehmlich CuAlO₂. Diese Hilfsschicht enthält vor allem kein CuO und kein CuAl₂O₄, aus welchen beiden Verbindungen sich während des Bondvorganges Sauerstoff abspalten kann, der sich negativ auf das Bondergebnis auswirkt, d.h. zur Bildung von Fehlstellen zwischen dem AlN-Substrat und der Kupferfolie führt. Aufgrund der erfindungsgemäß erfolgenden Eliminierung der Hauptursache für die Fehlstellenbildung kann diese Fehlstellenbildung zuverlässig verhindert werden, sie tritt auch beim Aufbonden von großflächigen Kupferfolien auf das AlN-Substrat nicht auf.

In weiterer Ausgestaltung der Erfindung kann vorgesehen sein, daß die Hilfsschicht zwischen 30 und 50 Gew.-% Cu₂O enthält.

Durch das Vorsehen von Cu₂O in der erfindungsgemäßen Hilfsschicht wird diese wesentlich besser von einem beim Aufbonden der Kupferschicht entstehenden Cu/CuO-Eutektikum benetzt. Es hat sich herausgestellt, daß sich gerade bei den angegebenen Anteilen von Cu₂O eine besonders gute Benetzbarkeit der Hilfsschicht ergibt und somit besonders gute Bondergebnisse erreicht werden können.

Weitere Aufgabe der Erfindung ist es, ein Verfahren zur Vorbereitung eines AlN-Substrates auf die Verbindung mit einer Kupferfolie mittels eines Direct-Copper-Bonding- (DCB-)Verfahrens anzugeben, bei dem auf zumindest eine Oberflächenseite des AlN-Substrates zur Herstellung einer Hilfsschicht eine Schicht aus Kupfer, Kupferoxid oder anderen kupferhältigen Verbindungen aufgebracht wird und anschließend ein Oxidationsvorgang durchgeführt wird, bei welchem in der Schicht CuAl₂O₄ ausgebildet wird. Die Anwendung des anzugebenden Verfahrens soll zu AlN-Substraten führen, bei welchen die oben angeführten Nachteile des bekannten Standes der Technik vermieden sind, d.h. auf welche in reproduzierbarer Weise selbst großflächige Kupferfolien (>4x4 Zoll) ohne Fehlstellen aufgebondet werden können.

Erfindungsgemäß wird dies dadurch erreicht, daß nach dem Oxidationsvorgang ein Reduktionsvorgang durchgeführt wird, bei welchem das in der Schicht enthaltene CuAl₂O₄ zu CuAlO₂ und CuO zu Cu₂O reduziert wird.

Damit entsteht eine Hilfsschicht, welche gerade jene beiden Verbindungen (CuAl₂O₄ und CuO), welche im bisher bekannten Stand der Technik Ursache für die Bildung von Fehlstellen waren, nicht aufweist. Die Fehlstellenbildung wird damit zuverlässig auch beim Aufbonden großflächiger Kupferfolien auf das AlN-Substrat vermieden.

In weiterer Ausgestaltung der Erfindung kann vorgesehen sein, daß der Oxidationsvorgang in Normalluft-Atmosphäre durchgeführt wird.

Es braucht damit keine Spezialatmosphäre geschaffen werden, womit der mit der Durchführung des erfindungsgemäßen Verfahrens verbundene Aufwand gering gehalten werden kann.

Als besonders günstig hat sich erwiesen, daß der Oxidationsvorgang bei Temperaturen im Bereich zwischen 1065°C und 1080°C, insbesondere bei 1075°C, durchgeführt wird.

Bei solchen Temperaturen ist das Verhältnis zwischen der Zeitdauer, während welcher die Oxidation durchgeführt werden muß, um die notwendige Bildung des Mischkristalles CuAl₂O₄ zu erreichen und dem technischen Aufwand zur Erzeugung dieser Temperaturen besonders günstig. Das erfindungsgemäße Verfahren kann daher bei diesem Temperaturen besonders effizient durchgeführt werden.

In weiterer Ausgestaltung der Erfindung kann vorgesehen sein, daß der Reduktionsvorgang in einer Stickstoff-Atmosphäre, die bis zu 1000ppm Sauerstoff enthält, durchgeführt wird.

Die Verwendung dieser Atmosphäre hat den Vorteil, daß die Ofeneinstellungen, d.h. die Temperatur, die Ofenkurve (d.h. die Temperaturveränderungen im Zeitablauf) und die Ofenatmosphäre gleich gewählt werden können, wie beim nachfolgenden Bondvorgang. Der mit der Durchführung des erfindungsgemäßen Verfahrens verbundene technische und wirtschaftliche Aufwand kann damit gering gehalten werden.

Gemäß einer bevorzugten Ausführungsform kann vorgesehen sein, daß der Reduktionsvorgang bei Temperaturen im Bereich zwischen 1065°C und 1080°C, insbesondere bei 1070°C, durchgeführt wird.

Auch im Zusammenhang mit dem Reduktionsvorgang ist bei diesen Temperaturen das Verhältnis zwischen dem Zeitaufwand für das Reduktionsverfahren und dem technischen Aufwand zur Erzeugung der Temperaturen besonders günstig, sodaß die Wahl dieser Temperaturen zu einer guten Gesamteffizienz des erfindungsgemäßen Verfahrens führt.

Weiters kann vorgesehen sein, daß der Reduktionsvorgang bei Unterdruck im Bereich von <1 bar durchgeführt wird.

Die beim Reduktionsvorgang stattfindenden chemischen Reaktionen können bei Unterdruck schneller ablaufen als bei Normaldruck, womit durch Verwendung einer Unterdruck-Atmosphäre die Gesamt-Ablaufdauer des erfindungsgemäßen Verfahrens verkürzt werden kann.

In weiterer Ausgestaltung der Erfindung kann vorgesehen sein, daß die Schicht aus Kupfer, Kupferoxid oder anderen kupferhältigen Verbindungen mit einer Schichtdicke im Bereich zwischen 0,14µm und 2µm, vorzugsweise im Bereich zwischen 0,5 bis 2 µm, insbesondere mit 1µm ausgebildet wird.

Bei diesen Schichtstärken kann sich das zur Ermöglichung des Bondprozesses notwendige CuAlO₂ in optimaler Menge bilden.

Die Erfindung wird unter Bezugnahme auf die beigeschlossenen Zeichnungen, in welchen besonders bevorzugte Ausführungsbeispiele dargestellt sind, näher beschrieben. Dabei zeigt:
Fig.1 einen vertikal geführten Schnitt durch ein nach dem erfindungsgemäßen Verfahren hergestelltes AlN-Substrat 1;
Fig.2 eine Röntgenbeugungsaufnahme eines AlN-Substrates 1 nach Durchführung des Oxidationsvorganges;
Fig.3 eine Röntgenbeugungsaufnahme eines AlN-Substrates 1 nach Durchführung des Reduktionsvorganges;
Fig.4 ein Photo einer Kupferfolie, die auf ein gemäß Stand der Technik vorbehandeltes AlN-Substrat aufgebondet wurde und
Fig.5 ein Photo einer auf ein erfindungsgemäßes AlN-Substrat 1 aufgebondeten Kupferfolie.

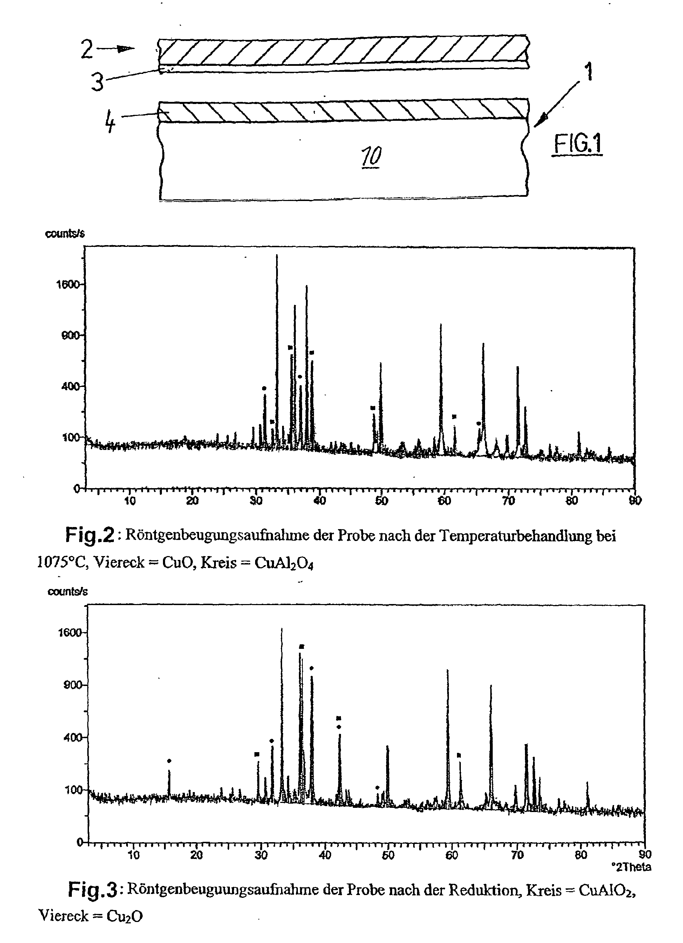

In Fig.1 ist mit 1 ein Substrat bezeichnet, das eine im wesentlichen aus Aluminiumnitrid (AlN) bestehende Schicht 10 umfaßt. Mit 2 ist eine Kupferfolie bezeichnet, die mittels eines an sich bekannten Direct-Copper-Bonding- (DCB-)Verfahrens mit dem AlN-Substrat 1 verbunden werden soll.

Da ein Bondvorgang nicht direkt auf einer aus AlN bestehenden Oberfläche durchgeführt werden kann (AlN wird von einem Cu/CuO-Eutektikum nicht benetzt), ist an jener Oberflächenseite, auf welcher eine Kupferfolie 2 festgelegt werden soll, eine Hilfsschicht 4 angeordnet. Diese ist mit einer solchen Zusammensetzung ausgebildet, daß sie vom Cu/CuO-Eutektikum benetzt wird, sodaß auf ihr eine Kupferfolie 2 mittels eines Direct-Copper-Bonding- (DCB-)Verfahrens festlegbar ist. Sollen abweichend von der Darstellung in Fig.1 auf beide Oberflächenseiten des AlN-Substrates 1 Kupferfolien 2 aufgebondet werden, sind selbstredend beide Oberflächenseiten mit einer derartigen Hilfsschicht 4 zu versehen.

Die Kupferfolie 2 kann an jener Oberflächenseite, mit welcher sie zur Anlage am AlN-Substrat 1 kommen soll, mit einer Oxidschicht 3 versehen sein, welche Oxidschicht 3 den zur Bildung des Cu/CuO-Eutektikums notwendigen Sauerstoff liefert. Sollte dieser Sauerstoff in ausreichendem Maß auf andere Weise zur Verfügung gestellt werden, beispielsweise von der am AlN-Substrat 1 angeordneten Hilfsschicht 4, braucht die Oxidschicht 3 an der Kupferfolie 2 nicht vorgesehen werden.

Die das Aufbonden der Kupferfolie 2 ermöglichende Hilfsschicht 4 ist erfindungsgemäß zum Großteil aus CuAlO₂ gebildet, d.h. sie enthält zumindest 50 Gew.-% CuAlO₂. Daneben ist Cu₂O in ihr enthalten, vorzugsweise in einem Ausmaß im Bereich zwischen 30 und 50 Gew.-%.

Die Herstellung einer derart zusammengesetzten Hilfsschicht kann grundsätzlich beliebig erfolgt. Es könnten beispielsweise CuAlO₂ und Cu₂O separat vom AlN-Substrat 1 hergestellt werden und anschließend auf das AlN-Substrat 1 durch mechanische Verfahren (z.B. Siebdruck oder Einbringen von CuAlO₂ und Cu₂O in ein Lösungsmittel (z.B. Alkohol) und

Auftragen dieser Suspension) aufgebracht werden.

Bevorzugt wird die Hilfsschicht 4 allerdings durch ein nachstehend erörtertes mechanischchemisches Verfahren hergestellt.

Bei diesem Verfahren wird auf zumindest eine Oberflächenseite des AlN-Substrates 1 zur Herstellung der Hilfsschicht 4 eine Schicht aus Kupfer, Kupferoxid oder anderen kupferhältigen Verbindungen aufgebracht.

Die konkrete Vorgangsweise zur Aufbringung dieser Schicht 4 ist nicht erfindungswesentlich und kann daher beliebig gewählt werden. Kupfer, Kupferoxid bzw. die anderen kupferhältigen Verbindungen können beispielsweise mittels Sputter-Prozessen, stromlose Abscheidung von Kupfer mit einem handelsüblichen Bad, Aufdampfen, Siebdrucken, Tauchen in Lösungen usw. aufgebracht werden.

Vorzugsweise wird eine Suspension aus Isopropylalkohol oder einem sonstigen organischen Lösungsmittel und Kupfer bzw. Kupferoxid bzw. anderen aufzubringenden kupferhältigen Verbindungen hergestellt und wird diese Suspension auf das AlN-Substrat aufgesprüht und das organische Lösungsmittel verdampfen lassen.

Die Dicke der aufgebrachten Schicht aus Kupfer, Kupferoxid oder anderen kupferhältigen Verbindungen liegt im Bereich zwischen 0,14µm und 2µm, üblicherweise werden Schichtdicken von 0,5 bis 2 µm, insbesondere 1µm gewählt.

Anschließend wird das AlN-Substrat 1 einem Oxidationsvorgang unterworfen, während welchem Kupfer, Kupferoxid bzw. andere Kupferverbindungen oxidiert werden und sich in der Schicht der Mischkristall CuAl₂O₄ bildet. Kupfer, Kupferoxid oder andere kupferhältige Verbindungen werden in einem größeren Ausmaß auf das AlN-Substrat aufgebracht, als zur Bildung des Mischkristalls CuAl₂O₄ notwendig wäre. Nach Abschluß des Oxidationsvorganges ist daher CuO im Überschuß vorhanden, wodurch die Bildung von Al₂O₃ weitgehend verhindert wird.

Das Ausbleiben der Bildung von Al₂O₃ hat sich durch folgendes Experiment bestätigt: Es wurde AlN-Pulver und Cu₂O-Pulver vermischt und diese Mischung einem Oxidationsvorgang unterzogen. Es wurde dabei vornehmlich der Mischkristall CuAl₂O₄ sowie CuO gebildet, Al₂O₃ ist hingegen nicht in meßbaren Mengen entstanden.

Der angesprochene Oxidationsvorgang wird dadurch herbeigeführt, daß das AlN-Substrat 1 in einer sauerstoffhältigen Atmosphäre, vorzugsweise in Normalluft-Atmosphäre, auf Temperaturen im Bereich zwischen 800°C und 1300°C aufgeheizt wird. Als besonders günstig haben sich hier Temperaturen im Bereich zwischen 1065°C und 1080°C erwiesen.

Das AlN-Substrat 1 wird solange auf den angegebenen Temperaturen gehalten, bis sich der geforderte Mischkristall CuAl₂O₄ flächendeckend gebildet hat. Die Auswahl der konkret notwendigen Oxidationsdauer ist von der konkret gewählten Temperatur bzw. von der Atmosphärenzusammensetzung und vom Atmosphärendruck abhängig.

Die Auswahl dieser einzelnen Parameter bzw. ihre Abstimmung aufeinander kann ohne weiteres vom Fachmann vorgenommen werden. Als Anhaltspunkt für die Oxidationsdauer kann ein Bereich zwischen zwölf Stunden und zehn Minuten angegeben werden.

Nach Abschluß dieses Oxidationsvorganges enthält die am AlN-Substrat 1 liegende Schicht neben CuAl₂O₄ noch CuO.

Würde bereits nach Abschluß dieses Oxidationsvorganges die Kupferfolie mittels DCB-Verfahren auf das AlN-Substrat 1 aufgebondet werden, könnte sich während des Bondvorganges Sauerstoff aus dem Mischkristall CuAl₂O₄ bzw. aus CuO abspalten. Dieser Sauerstoff würde die Ausbildung einer Bondingverbindung, die über die gesamte Fläche gleichmäßig ist, verhindern, weil damit eine örtlich Erhöhung der Sauerstoffkonzentration im Bereich des Cu/CuO-Eutektikums entstehen kann, die -praktischen Versuchen zufolge- so weit gehen kann, daß die aufgelegte Kupferplatte aufschmilzt (vgl. Fig.4).

Zur Verhinderung dieses Effektes sieht die Erfindung einen weiteren Vorbehandlungsschritt, nämlich einen Reduktionsvorgang, vor, bei welchem das in der Schicht enthaltene CuAl₂O₄ zu CuAlO₂ sowie das ebenfalls in der Schicht vorhandene CuO zu Cu₂O reduziert wird.

Dieser Reduktionsvorgang wird durch abermaliges Erhitzen des AlN-Substrates 1 auf Temperaturen im Bereich zwischen 800°C und 1300°C in stickstoffhältiger Atmosphäre herbeigeführt. Temperaturen zwischen 1065°C und 1080°C haben sich auch hier als günstig erwiesen. Die Atmosphäre, in welcher dieser Reduktionsvorgang durchgeführt wird, kann Sauerstoff enthalten. Es kann in diesem Sinn beispielsweise eine Stickstoff-Atmosphäre verwendet werden, die bis zu 1000 ppm Sauerstoff beinhaltet.

Während der Reduktion kann die das AlN-Substrat 1 umgebende Atmosphäre Normaldruck aufweisen. Es ist aber auch möglich, den Reduktionsvorgang bei Unterdruck durchzuführen, wobei sich Unterdrücke im Bereich von <1 bar als günstig erwiesen haben.

Auch die Dauer des Reduktionsvorganges, d.h. das Zeitintervall, während dessen das AlN-Substrat 1 erhitzt bleiben muß, ist abhängig von der konkret gewählten Temperatur, der konkreten Atmosphärenzusammensetzung und dem Atmosphärendruck.

Diese Parameter haben -was ein Fachmann ohne Schwierigkeiten durchführen kann- so gewählt und aufeinander abgestimmt zu werden, daß sämtliche CuAl₂O₄- und CuO-Moleküle zu CuAlO₂ bzw. Cu₂O reduziert werden. Die Reduktionsdauer kann dabei zwischen zwölf Stunden und einer Minute betragen.

Nach diesem Reduktionsvorgang ist die Herstellung der erfindungsgemäßen Hilfsschicht 4 abgeschlossen, sie enthält -wiederholend festgehalten- zumindest 50 Gew.-% CuAlO₂ sowie Cu₂O. Auf diese Hilfsschicht 4 kann jetzt eine Kupferfolie 2 durch ein an sich bekanntes und deshalb nicht näher beschriebenes DCB-Verfahren aufgebracht werden. Die Kupferfolie 2 wird dabei -wie aus dem Photo Fig.5 hervorgeht- vollflächig mit dem AlN-Substrat 1 verbunden, lokale Aufschmelzungen der Kupferfolie 2 treten nicht auf, weiters werden keine Blasen oder sonstige Fehlstellen gebildet.

Abschließend wird -ohne die Erfindung hierauf zu beschränken- folgendes konkretes, durch praktische Versuche bereits überprüftes Ausführungsbeispiel angegeben:
Ein 5 x 7 Zoll großes AlN-Substrat 1 mit einer Dicke von 0.63 mm wurde mit einer Suspension bestehend aus Cu₂O und Isopropylalkohol beschichtet. Die aufgebrachte Menge an Cu₂O liegt im Bereich von 30 bis 50 mg pro Oberflächenseite. Das so behandelte AlN-Substrat 1 wurde in einem Ofen an Luft auf 1075°C aufgeheizt, dort 0.5 Stunden gehalten und anschließend während mindestens 5 Stunden auf Zimmertemperatur abgekühlt. Dabei bildet sich in den am AlN-Substrat 1 aufgebrachten Schichten CuAl₂O₄ bzw. CuO, wie am besten aus Fig.2 hervorgeht. Die nicht beschrifteten Peaks dieser Röntgenbeugungsaufnahme stammen vom AlN des Substrates 1 bzw. von Mischphasen von AlN mit Sinterhilfsmittel.
Nach diesem Oxidationsvorgang wurde das AlN-Substrat 1 einem Reduktionsschritt durch abermaliges Aufheizen auf Temperaturen von größer 1065°C unterzogen. Dieses Aufheizen erfolgte in einer Stickstoff-Atmosphäre, die 200ppm Sauerstoff enthielt. Die genannte Temperatur wurde dabei für eine Zeitdauer von einigen Minuten aufrecht erhalten.
Dabei wurde das beim Oxidationsprozeß entstandene CuAl₂O₄ zu CuAlO₂ reduziert und auch überschüssiges CuO zu Cu₂O reduziert (vgl. Fig.3; auch die hierin nicht beschrifteten Peaks stammen vom AlN bzw. von Mischphasen von AlN mit Sinterhilfsmittel).
Al₂O₃, aus welchem Oxid die Hilfsschicht 4 nach bisher bekanntem Stand der Technik zumeist bestanden hat, konnte nicht in meßbaren Mengen festgestellt werden.
Nach dem Abkühlen des AlN-Substrates 1 wurden mittels DCB-Verfahren Kupferfolien 2 auf beiden Oberflächenseiten des AlN-Substrates 1 festgelegt, wobei jeweils vollflächige, fehlerstellenfreie Verbindungen entstanden sind.

## Patentansprüche

1. AlN-Substrat (1) mit wenigstens einer, im wesentlichen aus AIN bestehenden Schicht (10), die an wenigstens einer Oberflächenseite mit einer Hilfsschicht (4) versehen ist, auf welcher eine Kupferfolie (2) mittels eines Direct-Copper-Bonding- (DCB-)Verfahrens festlegbar ist, **dadurch gekennzeichnet, daß** diese Hilfsschicht (4) zu zumindest 50 Gew.-% aus CuAlO₂ besteht und im Überschuß vorhandenes Cu₂O enthält.

2. AlN-Substrat (1) nach Anspruch 1, **dadurch gekennzeichnet, daß** die Hilfsschicht (4) zwischen 30 und 50 Gew.-% Cu₂O enthält.

3. Verfahren zur Vorbereitung eines AlN-Substrates (1) auf die Verbindung mit einer Kupferfolie (2) mittels eines Direct-Copper-Bonding- (DCB-)Verfahrens, bei dem auf zumindest eine Oberflächenseite des AlN-Substrates (1) zur Herstellung einer Hilfsschicht (4) eine Schicht aus Kupfer, Kupferoxid oder anderen kupferhältigen Verbindungen aufgebracht wird und anschließend ein Oxidationsvorgang durchgeführt wird, bei welchem in der Schicht CuAl₂O₄ ausgebildet wird, **dadurch gekennzeichnet, daß** nach dem Oxidationsvorgang ein Reduktionsvorgang durchgeführt wird, bei welchem das in der Schicht enthaltene CuAl₂O₄ zu CuAlO₂ und CuO zu Cu₂O reduziert wird.

4. Verfahren nach Anspruch 1, **dadurch gekennzeichnet, daß** der Oxidationsvorgang in Normalluft-Atmosphäre durchgeführt wird.

5. Verfahren nach Anspruch 1 oder 2, **dadurch gekennzeichnet, daß** der Oxidationsvorgang bei Temperaturen im Bereich zwischen 1065°C und 1080°C, insbesondere bei 1075°C, durchgeführt wird.

6. Verfahren nach Anspruch 1, 2 oder 3, **dadurch gekennzeichnet, daß** der Reduktionsvorgang in einer Stickstoff-Atmosphäre, die bis zu 1000ppm Sauerstoff enthält, durchgeführt wird.

7. Verfahren nach einem der Ansprüche 1 bis 4, **dadurch gekennzeichnet, daß** der Reduktionsvorgang bei Temperaturen im Bereich zwischen 1065°C und 1080°C, insbesondere bei 1070°C, durchgeführt wird.

8. Verfahren nach einem der Ansprüche 1 bis 5, **dadurch gekennzeichnet, daß** der Reduktionsvorgang bei Unterdruck im Bereich von <1 bar durchgeführt wird.

9. Verfahren nach einem der Ansprüche 1 bis 5, **dadurch gekennzeichnet, daß** die Schicht (4) aus Kupfer, Kupferoxid oder anderen kupferhältigen Verbindungen mit einer Schichtdicke im Bereich zwischen 0,14µm und 2µm, vorzugsweise im Bereich zwischen 0,5 bis 2 µm, insbesondere mit 1 µm ausgebildet wird.

## Claims

1. AIN substrate (1) having at least one layer (10) which consists substantially of AIN and is provided on at least one surface side with an auxiliary layer (4) to which a copper foil (2) can be fixed using a direct copper bonding (DCB) process, **characterised in that** at least 50 % by weight of this auxiliary layer (4) consists of CuAlO₂ and contains excess Cu₂O.

2. AIN substrate (1) according to claim 1, **characterised in that** the auxiliary layer (4) contains between 30 and 50 % by weight of Cu₂O.

3. Process for preparing an AIN substrate (1) for bonding to a copper foil (2) using a direct copper bonding (DCB) process, wherein for producing an auxiliary layer (4) a layer of copper, copper oxide or other copper-containing compounds is attached to at least one surface side of the AIN substrate (1) and there is subsequently carried out an oxidation process in which CuAl₂O₄ is formed in the layer, **characterised in that** after the oxidation process there is carried out a reduction process in which CuAl₂O₄ contained in the layer is reduced to form CuAlO₂ and CuO is reduced to form Cu₂O.

4. Process according to claim 1, **characterised in that** the oxidation process is carried out in normal air atmosphere.

5. Process according to either claim 1 or claim 2, **characterised in that** the oxidation process is carried out at temperatures in the range between 1,065 °C and 1,080 °C, in particular at 1,075 °C.

6. Process according to claim 1, 2 or 3, **characterised in that** the reduction process is carried out in a nitrogen atmosphere containing up to 1,000 ppm of oxygen.

7. Process according to any one of claims 1 to 4, **characterised in that** the reduction process is carried out at temperatures in the range between 1,065 °C and 1,080 °C, in particular at 1,070 °C.

8. Process according to any one of claims 1 to 5, **characterised in that** the reduction process is carried out at reduced pressure in the range of < 1 bar.

9. Process according to any one of claims 1 to 5, **characterised in that** the layer (4) of copper, copper oxide or other copper-containing compounds is formed at a layer thickness in the range between 0.14 µm and 2 µm, preferably in the range from 0.5 to 2 µm, in particular at 1 µm.

## Revendications

1. Substrat en AIN (1) avec au moins une couche (10) composée pour l'essentiel d'AIN, qui est dotée sur au moins une face de surface d'une couche auxiliaire (4) sur laquelle une feuille de cuivre (2) peut être fixée au moyen d'un procédé de diffusion directe du cuivre (DCB), **caractérisé en ce que** la couche auxiliaire (4) se compose à au moins 50 % en poids de CuAlO₂ et contient du Cu₂O en excédent.

2. Substrat en AIN (1) selon la revendication 1, **caractérisé en ce que** la couche auxiliaire (4) contient entre 30 et 50 % en poids de Cu₂O.

3. Procédé pour la préparation d'un substrat en AIN (1) en vue de la liaison avec une feuille de cuivre (2) au moyen d'un procédé de diffusion directe du cuivre (DCB), dans lequel, sur au moins une face de surface du substrat en AIN (1), en vue de produire une couche auxiliaire (4), une couche de cuivre, d'oxyde de cuivre ou d'autres composés contenant du cuivre est appliquée puis une opération d'oxydation est exécutée, pendant laquelle du CuAl₂O₄ se forme dans la couche, **caractérisé en ce qu'**est réalisée après l'opération d'oxydation une opération de réduction lors de laquelle le CuAl₂O₄ contenu dans la couche est réduit en CuAlO₂ et le CuO en Cu₂O.

4. Procédé selon la revendication 1, **caractérisé en ce que** l'opération d'oxydation est réalisée sous une atmosphère d'air normal.

5. Procédé selon la revendication 1 ou 2, **caractérisé en ce que** l'opération d'oxydation est exécutée à une température comprise entre 1065°C et 1080°C, en particulier à 1075°C.

6. Procédé selon la revendication 1, 2 ou 3, **caractérisé en ce que** l'opération de réduction est exécutée dans une atmosphère d'azote contenant jusqu'à 1000 ppm d'oxygène.

7. Procédé selon l'une des revendications 1 à 4, **caractérisé en ce que** l'opération de réduction est exécutée à une température comprise entre 1065°C et 1080°C, en particulier à 1070°C.

8. Procédé selon l'une des revendications 1 à 5, **caractérisé en ce que** l'opération de réduction est exécutée sous une dépression de l'ordre de <1 bar.

9. Procédé selon l'une des revendications 1 à 5, **caractérisé en ce que** la couche (4) en cuivre, en oxyde de cuivre ou en autres composés contenant du cuivre est formée avec une épaisseur de couche comprise entre 0,14 µm et 2 µm, de préférence entre 0,5 et 2 µm et en particulier de 1 µm.
